# EUROPEAN PATENT APPLICATION

(11) **EP 4 685 178 A1**
(43) Date of publication of application: **28.01.2026**
(21) Application number: 25191495.8
(22) Date of filing: 24.07.2025
(51) Int. Cl.: C08K 3/08, C08K 3/22, C08K 3/38, C08K 3/28, H02M 1/00, H05K 9/00

(54) **PHOSPHONIC ACID FOR ENHANCING PERFORMANCE OF THERMAL INTERFACE MATERIALS**

(30) Priority: 26.07.2024 US 202463676133 P; 09.08.2024 US 202463681531 P
(71) Applicant: Laird Technologies, Inc., Chesterfield, MO 63017 (US)
(72) Inventor: OLDER, Christina M., Chesterfield, 63017 (US); PATTERSON, Anastasia Lily, Chesterfield, 63017 (US); NWACHUKWU, Chideraa Iheanyi, Chesterfield, 63017 (US); LIANG, Ruiqi, Chesterfield, 63017 (US); METH, Jeffrey Scott, Chesterfield, 63017 (US); BERNARD, Stephanie Ann, Chesterfield, 63017 (US)
(74) Representative: Lind Edlund Kenamets Intellectual Property AB

(57) **Abstract**

The present disclosure relates to the use of phosphonic acid to enhance performance of thermal interface materials (broadly, composites), *e.g*., by improving rheological properties, improving aging properties, improving shelf life, improving tack/adhesion, and/or reducing the spreading of material(s), if any, migrating therefrom (*e.g.*, reduced oil bleed spreading, *etc.*)*.* The present disclosure also relates to methods of using phosphonic acids for enhancing performance of composites useful for management of heat and/or electromagnetic interference (EMI). The composite may comprise thermal management and/or electromagnetic interference (EMI) mitigation materials, such as thermal interface materials (TIMs), EMI absorber materials, thermally-conductive EMI absorber materials, electrically-conductive materials, combinations thereof, *etc.*

## Description

### FIELD

The present disclosure relates to the use of phosphonic acid to enhance performance of thermal interface materials (broadly, composites), *e.g.,* by improving rheological properties, improving aging properties, improving shelf life, improving tack/adhesion, and/or reducing the spreading of material(s), if any, migrating therefrom *(e.g.,* reduced oil bleed spreading, *etc.).*

### BACKGROUND

This section provides background information related to the present disclosure which is not necessarily prior art.

Electrical components, such as semiconductors, integrated circuit packages, transistors, *etc.,* typically have pre-designed temperatures at which the electrical components optimally operate. Ideally, the pre-designed temperatures approximate the temperature of the surrounding air. But the operation of electrical components generates heat. If the heat is not removed, the electrical components may then operate at temperatures significantly higher than their normal or desirable operating temperature. Such excessive temperatures may adversely affect the operating characteristics of the electrical components and the operation of the associated device.

To avoid or at least reduce the adverse operating characteristics from the heat generation, the heat should be removed, for example, by conducting the heat from the operating electrical component to a heat sink. The heat sink may then be cooled by conventional convection and/or radiation techniques. During conduction, the heat may pass from the operating electrical component to the heat sink either by direct surface contact between the electrical component and heat sink and/or by contact of the electrical component and heat sink surfaces through an intermediate medium or thermal interface material (TIM). The thermal interface material may be used to fill the gap between thermal transfer surfaces, in order to increase thermal transfer efficiency as compared to having the gap filled with air, which is a relatively poor thermal conductor.

In addition, a common problem in the operation of electronic devices is the generation of electromagnetic radiation within the electronic circuitry of the equipment. Such radiation may result in electromagnetic interference (EMI) or radio frequency interference (RFI), which can interfere with the operation of other electronic devices within a certain proximity. Without adequate shielding, EMI/RFI interference may cause degradation or complete loss of important signals, thereby rendering the electronic equipment inefficient or inoperable.

The term "EMI" as used herein should be considered to generally include and refer to EMI emissions and RFI emissions, and the term "electromagnetic" should be considered to generally include and refer to electromagnetic and radio frequency from external sources and internal sources. Accordingly, the term shielding (as used herein) broadly includes and refers to mitigating (or limiting) EMI and/or RFI, such as by absorbing, reflecting, blocking, and/or redirecting the energy or some combination thereof so that it no longer interferes, for example, for government compliance and/or for internal functionality of the electronic component system.

### DETAILED DESCRIPTION

Example embodiments will now be described more fully with reference to the accompanying drawings.

As recognized herein, thermal interface materials (TIMs) are subject to significant performance requirements, which continue to increase as devices use more power and are further integrated into sensitive electronics or field applications such as automotive. After recognizing the above, exemplary embodiments were developed and/or are disclosed herein including the use of phosphonic acids to enhance performance in TIMs (broadly, composites) contributing towards properties such as rheology, aging, shelf life, bleed, and/or adhesion.

In exemplary embodiments disclosed herein, phosphonic acid is used to enhance performance of a thermal interface material (TIM) or other composite useful for the management of heat and/or electromagnetic interference (EMI). In some exemplary embodiments disclosed herein, the phosphonic acid is an additive that is directly added to the formulation for the TIM. In other exemplary embodiments, the TIM includes one or more fillers (*e.g.,* thermally-conductive particles, *etc.*) that are pretreated with the phosphonic acid, surface-modified with the phosphonic acid, and/or coated with the phosphonic acid.

By way of example, a TIM or other composite useful for the management of heat and/or electromagnetic interference (EMI) may include one or more fillers (*e.g.,* thermally-conductive particles, *etc.*) on which has been deposited one or more thin film(s), coating(s), or layer(s) of phosphonic acid via liquid phase deposition. During the liquid phase deposition process, organic solvents may be used to facilitate the interaction between the phosphonic acid groups and the filler particle surfaces. An example liquid phase deposition process may include preparing a toluene, alcohol, ester or hydrocarbon solution that contains phosphonic acid. The mixture is then stirred with the filler particles to be treated. The fillers particles are washed with solvent, and the solvent is removed.

By way of further example, a TIM or other composite useful for the management of heat and/or electromagnetic interference (EMI) may include one or more fillers (*e.g.,* thermally-conductive particles, *etc.*) that are treated by a spray-on method or other suitable method for the bulk deposition onto powders. During the spray-on method, one or more thin film(s), coating(s), or layer(s) of phosphonic acid may be deposited on the filler particle surfaces. An example method may include preparing a solution of phosphonic acid in a suitable solvent and placing the solution and filler particles (*e.g.,* powder, *etc.*) in a high intensity solid mixer (*e.g.* twin cone mixer with intensifier, *etc.*)*.*

The TIM resin may comprise siloxane and/or hydrocarbon polymer(s), *e.g.,* a crosslinked siloxane resin system, an uncrosslinked siloxane resin system, an uncrosslinked hydrocarbon resin system, or a crosslinked hydrocarbon resin system. The TIM may also include one or more oil(s), stabilizer(s), dispersant(s), coupling agent(s), pigment(s), thixotropy agents, rheological modifier(s), tackifier(s) and/or solvent(s). The TIM may further include one or more fillers (*e.g.,* ranging in size from 0.1 µm to 500 µm (D50), *etc.*)*,* such as alumina, zinc oxide, aluminum, carbonyl iron, silicon carbide, boron nitride, silver, aluminum nitride, barium titanate, carbon, graphite, other thermally-conductive and/or EMI absorbing fillers, combinations thereof, *etc.* In various resin and filler systems, the phosphonic acid contributes improvements to rheological properties, aging properties (hardening when exposed to high temperatures in air or high temperature/humidity conditions), shelf life, bleed, and/or tack/adhesion.

Siloxane generally refers to a compound (*e.g.,* silicone, *etc.*) with a molecular structure based on a chain or functional group of alternating silicon and oxygen atoms, often with organic groups attached to the silicon atoms. Common siloxanes include silicones, PDMS (polydimethyl siloxane), silicone rubbers, silicone oils, liquid silicones, dimethicones, *etc.*

Disclosed are exemplary composites that are useful for the management of heat and/or electromagnetic interference (EMI). In exemplary embodiments, the composite comprises a matrix, one or more fillers within the matrix, and phosphonic acid. For example, the composite may include about 0.01 weight percent to about 3 weight percent of phosphonic acid based on a total weight of the composite, which amount of phosphonic acid is sufficient to enhance performance of the composite. The phosphonic acid may be an additive that is directly added to a formulation of the composite, and/or the composite may comprise one or more fillers pretreated, surface-modified, and/or coated with the phosphonic acid.

By way of example, ToF-SIMS (Time-of-Flight Secondary Ion Mass Spectrometry) can be performed on the full material to identify phosphonic acid species. In an uncrosslinked system, particles can be isolated and analyzed by ToF-SIMS, DRIFTS IR spectroscopy (Diffuse reflectance infrared Fourier transform spectroscopy), or XPS (X-ray photoelectron spectroscopy). In a crosslinked or uncrosslinked system, free phosphonic acid in the matrix can be isolated by dissolution or extraction into solvent, and the extract may be analyzed with UPLC/HPLC-MS, GC-MS, FTIR, or NMR.

In exemplary embodiments, the phosphonic acid may comprise octadecylphosphonic acid, tetradecylphosphonic acid, and/or dodecylphosphonic acid. The phosphonic acid may comprise an organic moiety bonded to the phosphorous atom directly through a carbon atom. Preferred phosphonic acids have an organic ligand consisting of aliphatic hydrocarbon moiety from about 2 to 20 carbon atoms. Suitable aliphatic organic ligands may be linear, branched, star-shaped, or cyclic; saturated or unsaturated; and may be optionally substituted with one or more functional groups, including silyl, siloxane, fluoroalkyl, aromatic, thiol, alcohol, carboxylic acid, amine, or amide substituents. Other suitable phosphonic acids may have an organic ligand with oligomeric or polymeric structure, with linear, branched, star-shaped, or cyclic structure, containing repeat units of polyacrylate, polymethacrylate, polystyrene, polysiloxane, polyester, polyamide, polybutadiene, hydrogenated polybutadiene, polypropylene, polyethylene, or other chemistries. The phosphonic acid may contain one or more phosphonic acid groups.

In exemplary embodiments, the composite includes at least about 0.05 weight percent but not more than about 0.25 weight percent of the phosphonic acid. Or the composite includes at least about 0.1 weight percent but not more than about 0.3 weight percent of the phosphonic acid. By way of example only, the composite may include about 0.05, 0.1, 0.25, or 0.3 weight percent of the phosphonic acid.

As disclosed herein, the phosphonic acid enhances performance of the composite as compared to another composite having substantially the same formulation but without the phosphonic acid. For example, the phosphonic acid may enhance performance of the composite (as compared to another composite having substantially the same formulation but without the phosphonic acid) by one or more of: improving rheological properties of the composite; improving aging properties of the composite; improving shelf life of the composite; improving tack/adhesion; and/or reducing the spreading of material(s), if any, migrating from the composite.

In exemplary embodiments, the phosphonic acid enhances performance of the composite (as compared to another composite having substantially the same formulation but without the phosphonic acid) by one or more of: increasing flow rate (grams/minute), increasing the time until brittle (*e.g.,* at 150 °C or 200 °C, at 85 percent relative humidity and a temperature of 40, 85, and/or 130 °C, *etc.*) as measured by various tests (*e.g.,* measuring thermal resistance, shore hardness, bend radius, *etc.*)*,* enabling the composite to achieve a higher deflection, enhancing tackiness measured via various methods (*e.g.,* peak detached pressure or adhesion, *etc.*)*,* reducing minimum bond line thickness (BLT) at equivalent pressures, reducing thermal resistance, lowering elastic modulus, and/or any combination of two or more of these performance enhancements.

In exemplary embodiments, the phosphonic acid enhances performance of the composite (as compared to another composite having substantially the same formulation but without the phosphonic acid) such that the composite is able to achieve one or more of: a higher deflection, enhanced tackiness measured via adhesion, and/or reduced minimum bond line thickness (BLT) after aging at 150 °C for two weeks or three weeks.

In exemplary embodiments, the phosphonic acid enhances performance of the composite (as compared to another composite having substantially the same formulation but without the phosphonic acid) such that the composite is able to achieve one or more of reduced thermal resistance and/or reduced minimum bond line thickness (BLT) after aging at high temperature and high relative humidity. For example, the phosphonic acid may enhance performance of the composite (as compared to another composite having substantially the same formulation but without the phosphonic acid) such that the composite is able to achieve one or more of reduced thermal resistance and/or reduced minimum bond line thickness (BLT) after aging for 48 hours at a temperature of 85 °C and a relative humidity of 85%. As another example, the phosphonic acid may enhance performance of the composite (as compared to another composite having substantially the same formulation but without the phosphonic acid) such that the composite is able to achieve a lower elastic modulus after aging for one week at a temperature of 130 °C and a relative humidity of 85%.

In exemplary embodiments, the composite includes a matrix that comprise a siloxane and/or hydrocarbon polymer(s). For example, the matrix may comprise a crosslinked siloxane resin system, an uncrosslinked siloxane resin system, an uncrosslinked hydrocarbon resin system, or a crosslinked hydrocarbon resin system. The composite may comprise one or more oil(s), stabilizer(s), dispersant(s), coupling agent(s), pigment(s), thixotropy agents, rheological modifier(s), tackifier(s) and/or solvent(s).

In exemplary embodiments, the composite comprises thermally-conductive particles pretreated with the phosphonic acid, thermally-conductive filler particles surface-modified with the phosphonic acid, and/or thermally-conductive filler particles coated with the phosphonic acid. The thermally-conductive particles may comprise alumina, zinc oxide, aluminum, and/or other thermally-conductive filler particles. By way of example, the composite may include zinc oxide particles pretreated, surface modified, and/or coated with phosphonic acid such that the composite includes about 0.01 weight percent of the phosphonic acid.

In exemplary embodiments, the composite includes a matrix that comprises a crosslinked siloxane resin system. The composite also includes zinc oxide filler and/or alumina filler within the matrix such that the composite includes at least 90 weight percent of the zinc oxide filler and/or the alumina filler.

In exemplary embodiments, the composite includes a matrix that comprises a crosslinked siloxane resin system. The composite also includes zinc oxide filler and one or more different alumina fillers within the matrix such that the composite includes at least 90 weight percent of the zinc oxide filler and/or the one or more different alumina fillers. The composite also includes at least 0.067 weight percent but not more than about 0.2 weight percent of the phosphonic acid.

In exemplary embodiments, the composite includes a matrix that comprises a crosslinked siloxane resin system. The composite also includes one or more different alumina fillers within the matrix such that the composite includes at least 90 weight percent of the one or more different alumina fillers. The composite also includes at least 0.05 weight percent but not more than about 0.2 weight percent of the phosphonic acid.

In exemplary embodiments, the composite includes a matrix that comprises an uncrosslinked siloxane resin system. The composite also includes zinc oxide filler and one or more different alumina fillers within the matrix such that the composite includes at least 90 weight percent of the zinc oxide filler and the one or more different alumina fillers. The composite also includes at least 0.09 weight percent but not more than about 0.25 weight percent of the phosphonic acid.

In exemplary embodiments, the composite includes a matrix that comprises an uncrosslinked hydrocarbon resin system. The composite also includes zinc oxide filler and one or more different aluminum powders within the matrix such that the composite includes at least 90 weight percent of the zinc oxide filler and the one or more different alumina fillers. The composite also includes at least 0.12 weight percent but not more than about 0.25 weight percent of the phosphonic acid.

### EXAMPLES

The following examples are provided to illustrate performance enhancements achievable with the use of phosphonic acid as disclosed herein. Accordingly, the following examples are provided for purposes of illustration only and not for purposes of limitation.

### Crosslinked Silicone Resin System Examples

Example formulations in weight percent (wt%) are set forth in Table 1 below for five test samples including a control sample #1 without any phosphonic acid.

**Table 1: Example Formulations with Crosslinked Silicone Resin System**

| **Sample #** | **Silicone Matrix A (wt%)** | **Crosslinker (wt%)** | **Catalyst (wt%)** | **Phosphonic Acid (wt%)** | **Ceramic Filler A** | **Ceramic Filler B** |
|---|---|---|---|---|---|---|
| Control 1 | 8.93% | 0.01% | 0.0058% | 0% | 12.0% | 79% |
| 2 | 8.94% | 0.01% | 0.0057% | 0.067% | 12.0% | 79% |
| 3 | 9.01% | 0.01% | 0.0057% | 0.13% | 12.0% | 79% |
| 4 | 8.80% | 0.01% | 0.0057% | 0.16% | 12.0% | 79% |
| 5 | 8.70% | 0.01% | 0.0057% | 0.20% | 12.0% | 79% |

Table 2 below includes test results for the five samples. Peak detach pressure, minimum bond line, and adhesion (G1c) were measured using an Instron MTS Criterion, Model 42 equipped with 1-inch diameter circular platens. A 1-inch diameter sample was compressed at a rate of 0.012 mm/min to a maximum of 450 N of force. The minimum bond line was the thickness of the sample at 450 N. The maximum deflection scaled the minimum bond line by the initial thickness. After the maximum force was achieved, the platen was retracted at 0.012 mm/min. The peak detached pressure was recorded as the maximum force per unit area experienced during this tensile displacement. The adhesion was calculated from the area under the tensile stress-strain curve.

**Table 2: Test Results**

| | **Before aging** | | | |
|---|---|---|---|---|
| **Sample #** | **Maximum deflection** | **Peak detached pressure (kPa)** | **Adhesion (J/m²)** | **Minimum bond line (mm)** |
| Control 1 | 15.5% | 0.0167 | 6.4E-09 | 2.04 |
| 2 | 20.3% | 0.922 | 5.6E-07 | 1.57 |
| 3 | 26.8% | 49.8 | 0.52 | 0.96 |
| 4 | 65.4% | 73.8 | 1.81 | 0.71 |
| 5 | 67.2% | 112 | 2.68 | 0.57 |

### Crosslinked Silicone Resin System Examples

Example formulations in weight percent (wt%) is set forth in Table 3 for a control sample 6 without any phosphonic acid and sample 7.

**Table 3: Example Formulations with Crosslinked Silicone Resin System**

| **Component** | **Control Sample 6** | **Sample 7** |
|---|---|---|
| Silicone Matrix B (wt%) | 6.42% | 6.35% |
| Catalyst (wt%) | 0.005% | 0.004% |
| Phosphonic Acid (wt%) | 0% | 0.05% |
| Ceramic Filler B (wt%) | 93.58% | 93.6% |

Table 4 below includes a summary of physical properties for five test samples 6 through 10. As shown, formulations containing phosphonic acid with loadings up to 0.1 wt% exhibited superior performance compared to those without phosphonic acid, which included higher deflection, enhanced tackiness (measured via adhesion), reduced bondline thickness (BLT), and lower elastic modulus.

**Table 4: Summary of Physical Properties**

| **Formulation details** | | **Performance after aging at 150 °C for 3 weeks** | | | | **Performance after aging at 130 °C and 85% RH for 1 week** |
|---|---|---|---|---|---|---|
| **Sample #** | **Wt% Phosphonic Acid** | **Deflection at 20 psi** | **Max deflection** | **Adhesion (J/m²)** | **Minimum bondline thickness (mm)** | **Elastic modulus at 20 °C (MPa)** |
| **Control 6** | 0% | 3% | 21% | 0.78 | 1.59 | 15.5 |
| 7 | 0.05% | 6% | 29% | 0.56 | 1.36 | 3.0 |
| **8** | 0.06% | 13% | 36% | 1.20 | 1.45 | N.D. |
| **9** | 0.08% | 14% | 38% | 1.08 | 1.24 | N.D. |
| **10** | 0.10% | 15% | 64% | 2.22 | 0.75 | N.D. |

### Uncrosslinked Silicone Resin System Examples

Example formulations in weight percent (wt%) are set forth in Table 5 below. The preparation procedure for samples 12 through 16 included adding phosphonic acid, ceramic fillers A and B, and additives (*e.g.,* coupling agent, pigment, thixotropic agent, *etc.*) to a silicone matrix C.

**Table 5: Example Formulations with Uncrosslinked Silicone Resin System**

| **Component** | **Control 11** | **12** | **13** | **14** | **15** | **16** |
|---|---|---|---|---|---|---|
| Silicone Matrix C (wt%) | 2.13% | 2.09% | 2.03% | 2.01% | 2.03% | 2.03% |
| Additives (wt%) | 0.42% | 0.42% | 0.42% | 0.42% | 0.42% | 0.42% |
| Phosphonic Acid (wt%) | 0% | 0.09% | 0.20% | 0.25% | 0.20% | 0.20% |
| Ceramic Filler A (wt%) | 12.58% | 12.58% | 12.58% | 12.58% | 12.58% | 12.58% |
| Ceramic Filler B (wt%) | 82.74% | 82.74% | 82.74% | 82.74% | 82.74% | 82.74% |

Samples were prepared and transferred to a 150°C oven on aluminum plates under air. Samples were subsequently checked at 3 days, 7 days, 10 days, then weekly afterwards. A sample was considered brittle if the material crumbled or cracked under gentle pressure from a metal spatula.

To measure flow rate for a dispensable TIM material, a Nordson EFP 75cc cartridge was filled with material, making sure not to leave any air voids. The piston was then placed and pushed down onto the material to remove any air gaps. The tapered nozzle (0.125" tip) was screwed on to the end of the cartridge. The filled cartridge was inserted into the Nordson EFD Fluid Dispenser assembly. The regulator on the EFD dispenser unit was set to the specified pressure (90 psi) and dispense time (20 sec). Before beginning the flow rate testing, some material was dispensed for ~10 seconds to fill the nozzle with material and remove any air pockets. A fresh aluminum weighing pan (tared) was placed below the sample cartridge. After the material has been dispensed, the weighing pan was removed with the material and the final weight was recorded. This test was repeated two more times with the remaining material in the cartridge/syringe for a total of three tests that were averaged for a final result.

**Table 6: Test Results**

| **Sample #** | **Phosphonic Acid loading (wt%)** | **Flow rate (g/min)** | **Time until brittle at 150 °C (days)** | **Time until brittle at 200 °C (days)** |
|---|---|---|---|---|
| Control 11 | 0% | 65.9 | 10 | 1 |
| 12 | 0.09% | 99.5 | 35 | N.D. |
| 13 | 0.20% | 97.2 | 91 | 5 |
| 14 | 0.25% | 95.8 | 91 | 3 |
| 15 | 0.20% | 95.0 | 77 | N.D. |
| 16 | 0.20% | 30.8 | 84 | N.D. |

### Uncrosslinked Silicone Resin System Examples

Example formulations in weight percent (wt%) are set forth in Table 7 below. The preparation procedure for examples 17 through 20 included phosphonic acid pretreated onto ceramic filler A. The pretreated ceramic filler A, a ceramic filler B, and different additives were added to a silicone matrix D. Example 17 included using octadecylphosphonic. Examples 18 and 19 included using dodecylphosphonic acid. Example 19 included using tetradecylphosphonic acid. Comparative Example 1 (Comp. Ex. 1) included using commercially-available propionic acid-surface modified ceramic filler A, while Comparative Example 2 (Comp. Ex. 2) used lauric acid-surface modified ceramic filler A.

**Table 7: Example Formulations with Uncrosslinked Silicone Resin System**

| **Component** | **Control 1** | **17** | **18** | **Control 2** | **19** | **Comp. Ex. 1** | **20** | **Comp. Ex. 2** |
|---|---|---|---|---|---|---|---|---|
| Silicone Matrix D | 2.13% | 2.13% | 2.13% | 2.13% | 2.13% | 2.13% | 2.13% | 2.13% |
| Additives (wt%) | 0.42% | 0.42% | 0.42% | 0.42% | 0.42% | 0.42% | 0.42% | 0.42% |
| Ceramic Filler A (wt%) | 12.58% | 12.58% | 12.58% | 12.58% | 12.58% | 12.58% | 12.58% | 12.58% |
| Ceramic Filler B (wt%) | 82.74% | 82.74% | 82.74% | 82.74% | 82.74% | 82.74% | 82.74% | 82.74% |

The samples were aged the same as when the phosphonic acid was added to the formulation directly as explained above. Table 8 below includes test results for the controls that did not include ceramic filler A pretreated with phosphonic acid and the examples 17, 18, 19, and 20 that included ceramic filler A pretreated with phosphonic acid.

**Table 8 Results for Uncrosslinked Silicone Resin Systems with Ceramic Filler A Pretreated with Phosphonic Acid**

| **Sample #** | **Ceramic Filler A Source** | **Treatment Process for Ceramic Filler A** | **Flow rate (g/min)** | **Time until brittle at 150 °C (days)** | **Time until brittle at 200 °C (days)** |
|---|---|---|---|---|---|
| Control 1 | 1 | Untreated | 65.9 | 10 | 1 |
| Example 17 | 1 | Pretreated | 72.7 | 65 | N.D. |
| Example 18 | 1 | Pretreated | 137.2 | 84 | 5 |
| Control 2 | 2 | Untreated | 82.6 | 12 | N.D. |
| Example 19 | 2 | Pretreated | 93.3 | 93 | N.D. |
| Comparative Example 1 | 3 | Pretreated with propionic acid | 74.2 | 12 | N.D. |
| Example 20 | 1 | Pretreated | 97.7 | 80 | N.D. |
| Comparative Example 2 | 1 | Lauric Acid | 110.7 | 14 | N.D. |

### Uncrosslinked Hydrocarbon Resin System Examples

Table 9 includes example formulations with uncrosslinked hydrocarbon resin systems. Samples having a target thickness of 200 µm were prepared for testing.

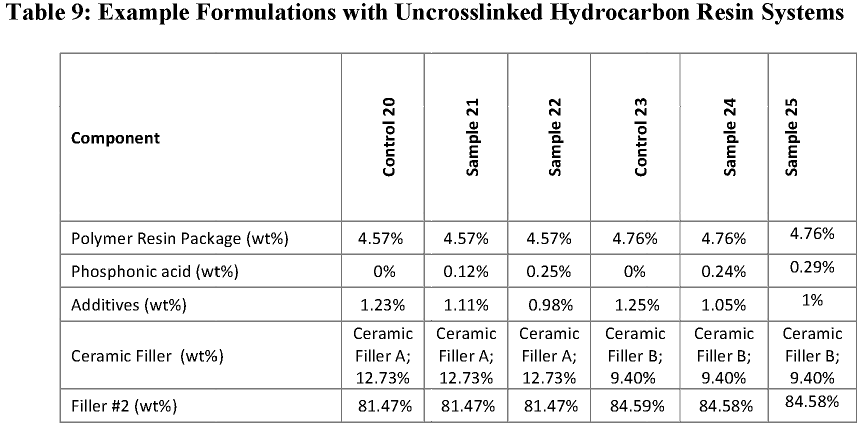

Samples were prepared between liners and placed in a humidity chamber at 85 °C and 85% relative humidity for 48 hours. Post-aging properties (thermal resistance, minimum bondline) were measured on a TIMA 5 instrument at 70 °C, which results are in Table 10 below.

**Table 10 Results for Uncrosslinked Hydrocarbon Resin Systems**

| **Formulation details** | | | **After aging at 85 °C / 85%RH / 48 hr** | |
|---|---|---|---|---|
| **Sample #** | **Ceramic Filler** | **Wt% Phosphonic Acid** | **Thermal resistance (cm²·K/W)** | **Minimum bondline at 50 psi (µm)** |
| **Control 20** | Ceramic Filler A | 0% | 0.519 | 202 |
| **21** | Ceramic Filler A | 0.12% | 0.074 | 43 |
| **22** | Ceramic Filler A | 0.25% | 0.046 | 29 |
| **Control 23** | Ceramic Filler B | 0% | 0.552 | 184 |
| **24** | Ceramic Filler B | 0.24% | 0.048 | 26 |
| **25** | Ceramic Filler B | 0.29% | 0.051 | 27 |

As shown by Table 10 above, formulations containing phosphonic acid exhibited superior performance compared to those without phosphonic acid, with reduced thermal resistance and minimum bondline thickness after aging at high temperature and humidity.

In exemplary embodiments, a thermal interface material comprises a composite as disclosed herein. The thermal interface material comprises a thermally-conductive pad, a thermally-conductive gap filler, a phase change thermal interface material, a dispensable material, a bulk putty, a thermal grease, a sheet of thermal interface material, a thermal transport layer in an optical module, *etc.* For example, the thermal interface material may comprise a thermally-conductive pad having a shape that is rectangular, triangular, circular, ovular, polygonal, *etc.* The thermal interface material may comprise a sheet having a shape that is rectangular, triangular, circular, ovular, polygonal, *etc.* The thermal interface material may comprise a die cut part having a shape that is rectangular, triangular, circular, ovular, polygonal, *etc.*

In exemplary embodiments, the composite includes one or more fillers that comprise one or more of: thermally-conductive filler(s); electrically-conductive filler(s); electromagnetic wave absorbing filler(s); dielectric filler(s); and filler(s) that has two or more properties of being thermally conductive, electrically conductive, dielectric, and electromagnetic wave absorbing. In exemplary embodiments, the composite includes one or more fillers that comprise one or more of alumina, zinc oxide, aluminum, carbonyl iron, silicon carbide, boron nitride, silver, aluminum nitride, barium titanate, carbon, graphite, other typical thermally-conductive and/or EMI absorbing fillers, combinations thereof, *etc.* And the one or more fillers may have a D₅₀ median particle size in a range from about 0.1 micrometers to about 500 micrometers.

In exemplary embodiments, the composite includes thermally-conductive filler and EMI absorbing filler in the matrix such that the composite comprises a multifunctional EMI absorber having a first functionality of EMI mitigation and a second functionality of thermal management, or vice versa. By way of example, the fillers may comprise one or more of functional nanoparticles, electrically-conductive fillers, thermally-conductive fillers, EMI or microwave absorbing fillers, magnetic fillers, coated fillers, combinations thereof, *etc.* The fillers may be added and mixed into a bulk material including the matrix material to thereby provide a mixture of the filler and base or matrix material. Example fillers include carbon black, boron nitride, nickel cobalt, carbonyl iron, iron silicide, iron particles, iron-chrome compounds, silver, an alloy containing 85% iron, 9.5% silicon and 5.5% aluminum, an alloy containing about 20% iron and 80% nickel, ferrites, magnetic alloys, magnetic powders, magnetic flakes, magnetic particles, nickel-based alloys and powders, chrome alloys, oxide, copper, zinc oxide, alumina, graphite, ceramics, silicon carbide, manganese zinc, fiberglass, carbon nanotubes (*e.g.,* single-walled carbon nanotubes, multi-walled carbon nanotubes, and/or carbon nanostructures, *etc.*)*,* combinations thereof, *etc.* The fillers may comprise one or more of granules, spheroids, microspheres, ellipsoids, irregular spheroids, strands, flakes, powder, nanotubes, and/or a combination of any or all of these shapes. In addition, exemplary embodiments may also include different grades (*e.g.,* different sizes, different purities, different shapes, *etc.*) of the same (or different) fillers.

In exemplary embodiments, the composite has a high thermal conductivity of at least 1 Watt per meter per Kelvin (W/mK) as determined by a Hot Disk Thermal Constants Analyzer. For example, the composite may have a thermal conductivity of 1 W/mK, 2 W/mK, 3 W/mK, 4 W/mK, 5 W/mK, more than 5 W/mK, *etc.* To determine thermal conductivity, a Hot Disk instrument may be used that measures thermal conductivity, thermal diffusivity, and specific heat capacity using the Transient Plane Source Method. By way of background, this technique is covered under the ISO 22007-2:2008; Part 2 Standard. The technique utilizes a plane sensor and a special mathematical model that describes the heat conductivity, combined with electronics that enables the method to be used to measure Thermal Transport Properties. It covers a thermal conductivity range of typically 0.01-500 W/m/K. The Transient Plane Source technique typically employs two samples halves sandwiching the sensor. This method can also be used in a single-sided configuration. The technique is versatile and fast, covering measurements of solids, pastes, thin films and liquids. The technique can test both isotropic and anisotropic material. The flat sensor includes a continuous double spiral of electrically conducting nickel metal, etched out of a thin foil. The nickel spiral is situated between two layers of thin polyimide film Kapton. During the measurement, a constant electrical effect is passed through the conducting spiral, increasing the sensor temperature. The heat generated dissipates into the sample on both sides of the sensor, at a rate depending on the thermal transport properties of the material. By recording temperature versus time response in the sensor, the thermal conductivity, thermal diffusivity, and specific heat capacity of the material can be calculated.

In exemplary embodiments, a device or system comprises a composite as disclosed herein that is used for managing thermal properties of the device or system.

Also disclosed are exemplary methods of using phosphonic acid to enhance performance of composite useful for management of heat and/or electromagnetic interference (EMI). In exemplary embodiments, the method comprises including about 0.01 weight percent to about 3 weight percent of phosphonic acid in the composite based on a total weight of the composite, which amount is sufficient to enhance performance of the composite (as compared to another composite having substantially the same formulation but without the phosphonic acid). The method may comprise pretreating, surface modifying, and/or coating the one or more fillers with the phosphonic acid. Additionally, or alternatively, the method may comprise adding the phosphonic acid as an additive to the composite's formulation. The composite may comprise thermal management and/or electromagnetic interference (EMI) mitigation materials, such as thermal interface materials (TIMs), EMI absorber materials, thermally-conductive EMI absorber materials, electrically-conductive materials, combinations thereof, *etc.*

In exemplary methods, the phosphonic acid may comprise an organic moiety bonded to the phosphorous atom directly through a carbon atom. Preferred phosphonic acids have an organic ligand consisting of aliphatic hydrocarbon moiety from about 2 to 20 carbon atoms. Suitable aliphatic organic ligands may be linear, branched, star-shaped, or cyclic; saturated or unsaturated; and may be optionally substituted with one or more functional groups, including silyl, siloxane, fluoroalkyl, aromatic, thiol, alcohol, carboxylic acid, amine, or amide substituents. Other suitable phosphonic acids may have an organic ligand with oligomeric or polymeric structure, with linear, branched, star-shaped, or cyclic structure, containing repeat units of polyacrylate, polymethacrylate, polystyrene, polysiloxane, polyester, polyamide, polybutadiene, hydrogenated polybutadiene, polypropylene, polyethylene, or other chemistries. The phosphonic acid may contain one or more phosphonic acid groups. The phosphonic acid may comprise one or more of octadecylphosphonic acid, tetradecylphosphonic acid, and/or dodecylphosphonic acid.

In exemplary methods, the use of the phosphonic acid enhances performance of the composite (as compared to another composite having substantially the same formulation but without the phosphonic acid) by one or more of: improving rheological properties of the composite; improving aging properties of the composite; improving shelf life of the composite; improving tack/adhesion; and/or reducing the spreading of material(s), if any, migrating from the composite.

In an exemplary embodiments, an electronic device includes a heat source and a composite as disclosed herein that is usable as a thermal interface material (e.g., thermally-conductive pad, a thermally-conductive gap filler, a phase change thermal interface material, a dispensable material, a bulk putty, a thermal grease, a sheet of thermal interface material, a thermal transport layer in an optical module, *etc.*)*.* The composite is positioned relative to the heat source for establishing at least a portion of a thermally-conductive heat path from the heat source through the composite. The composite may also be configured to be EMI absorbing and/or electrically conductive, such that the composite is also operable for mitigating and/or managing EMI within the electronic device.

In an exemplary embodiment, an electronic device includes a heat source, a heat removal/dissipation structure, and a composite as disclosed herein that is usable as a thermal interface material (*e.g.,* thermally-conductive pad, a thermally-conductive gap filler, a phase change thermal interface material, a dispensable material, a bulk putty, a thermal grease, a sheet of thermal interface material, a thermal transport layer in an optical module, *etc.*)*.* The composite is positioned relative to the heat source and the heat removal/dissipation structure for establishing at least a portion of a thermally-conductive heat path between the heat source and the heat removal/dissipation structure. The composite may also be configured to be EMI absorbing and/or electrically conductive, such that the composite is also operable for mitigating and/or managing EMI within the electronic device.

In an exemplary embodiment, an electronic device includes a heat source, a board level shield, and a composite disclosed herein that is usable as a thermal interface material (*e.g.,* thermally-conductive pad, a thermally-conductive gap filler, a phase change thermal interface material, a dispensable material, a bulk putty, a thermal grease, a sheet of thermal interface material, a thermal transport layer in an optical module, *etc.).* The composite is positioned relative to the heat source and the board level shield for establishing at least a portion of a thermally-conductive heat path between the heat source and the board level shield. The composite may also be configured to be EMI absorbing and/or electrically conductive, such that the composite is also operable for mitigating and/or managing EMI within the electronic device.

In an exemplary embodiment, an electronic device includes a heat source, a board level shield, a heat removal/dissipation structure, and first and second composites that are usable as thermal interface materials (*e.g.,* thermally-conductive pad, a thermally-conductive gap filler, a phase change thermal interface material, a dispensable material, a bulk putty, a thermal grease, a sheet of thermal interface material, a thermal transport layer in an optical module, *etc.*)*.* The first composite is positioned relative to the heat source and the board level shield for establishing at least a portion of a first thermally-conductive heat path between the heat source and the board level shield. The second composite is positioned relative to the board level shield and the heat removal/dissipation structure for establishing at least a portion of a second thermally-conductive heat path between the board level shield and the heat removal/dissipation structure. The first and/or second composites may also be configured to be EMI absorbing and/or electrically conductive, such that the first and/or second composites are also operable for mitigating and/or managing EMI within the electronic device.

In an exemplary embodiment, an electronic device includes an integrated circuit, a board level shield, a heat sink, and first and second composites that are usable as thermal interface materials (*e.g.,* thermally-conductive pad, a thermally-conductive gap filler, a phase change thermal interface material, a dispensable material, a bulk putty, a thermal grease, a sheet of thermal interface material, a thermal transport layer in an optical module, *etc.).* The first composite is positioned relative to the integrated circuit and the board level shield for establishing at least a portion of a first thermally-conductive heat path between the integrated circuit and the board level shield. The second composite is positioned relative to the board level shield and the heat sink for establishing at least a portion of a second thermally-conductive heat path between the board level shield and the heat sink. The first and/or second composites may also be configured to be EMI absorbing and/or electrically conductive, such that the first and/or second composites are also operable for mitigating and/or managing EMI within the electronic device.

Exemplary embodiments disclosed herein may be used in a wide range of industries (*e.g.,* automotive, consumer, industrial, datacom/telecom, aerospace/defense, *etc.*) and wide range of applications (*e.g.,* automotive electronics, automotive advanced driver-assistance systems (ADAS), automotive powertrain/electronic control units (ECUs), automotive infotainment, routers, hard disk drives, solid state drives, wireless infrastructure, drones/satellites, gaming systems, smart home devices, notebooks/tablets/portable devices, *etc.*)*.* In addition, example embodiments disclosed herein may be used for a wide range of heat sources, electronic devices, and/or heat removal/dissipation structures or components (*e.g.,* a heat spreader, a heat sink, a heat pipe, a vapor chamber, a device exterior case, housing, or chassis, *etc.*)*.* For example, a heat source may comprise one or more heat generating components or devices, such as a high-power integrated circuit (IC), optical transceiver, 5G infrastructure devices (*e.g.,* base stations, small cells, smart poles, *etc.*)*,* solid-state drive (SSD), memory in video cards, set top boxes, televisions, gaming systems, automotive electronics used for autonomous driving (ADAS) (*e.g.,* radars, multi domain controllers, cameras, *etc.*)*,* a CPU, die within underfill, semiconductor device, flip chip device, graphics processing unit (GPU), digital signal processor (DSP), multiprocessor system, integrated circuit (IC), multi-core processor, *etc.*)*.* Generally, a heat source may comprise any component or device that has a higher temperature than a thermal management and/or EMI mitigation material or otherwise provides or transfers heat to the thermal management and/or EMI mitigation material regardless of whether the heat is generated by the heat source or merely transferred through or via the heat source. Accordingly, aspects of the present disclosure should not be limited to use with any single type of heat source, electronic device, heat removal/dissipation structure, *etc.*

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific dimensions, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (*i.e.,* the disclosure of a first value and a second value for a given parameter can be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. For example, when permissive phrases, such as "may comprise", "may include", and the like, are used herein, at least one embodiment comprises or includes the feature(s). As used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance of the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (*e.g.,* "between" versus "directly between," "adjacent" versus "directly adjacent," *etc.).* As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about", equivalents to the quantities are included.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A composite useful for the management of heat and/or electromagnetic interference (EMI), the composite comprising:
a matrix;
one or more fillers within the matrix; and
a phosphonic acid.

2. The composite of claim 1, wherein the one or more fillers are pretreated with the phosphonic acid, surface-modified with the phosphonic acid, and/or coated with the phosphonic acid.

3. The composite of claim 1, wherein the phosphonic acid is an additive directly added to a formulation of the composite.

4. The composite of any one of the preceding claims, wherein the composite comprises about 0.01 weight percent to about 3 weight percent of phosphonic acid based on a total weight of the composite.

5. The composite of any one of the preceding claims, wherein:
the phosphonic acid comprises an organic moiety bonded to the phosphorous atom directly through a carbon atom; and/or
the phosphonic acid comprises an aliphatic organic ligand having aliphatic hydrocarbon moiety from about 2 to 20 carbon atoms, whereby the aliphatic organic ligand may be linear, branched, star-shaped, or cyclic structure and/or saturated or unsaturated; and/or
the phosphonic acid has an organic ligand with oligomeric or polymeric structure, with linear, branched, star-shaped, or cyclic structure, containing repeat units of polyacrylate, polymethacrylate, polystyrene, polysiloxane, polyester, polyamide, polybutadiene, hydrogenated polybutadiene, polypropylene, polyethylene, or other chemistries; and/or
the phosphonic acid includes one or more phosphonic acid groups.

6. The composite of any one of the preceding claims, wherein the phosphonic acid comprises one or more of:
octadecylphosphonic acid;
tetradecylphosphonic acid; and/or
dodecylphosphonic acid.

7. The composite of any one of the preceding claims, wherein the composite includes:
at least about 0.05 weight percent but not more than about 0.25 weight percent of the phosphonic acid; or
at least about 0.1 weight percent but not more than about 0.3 weight percent of the phosphonic acid.

8. The composite of any one of the preceding claims, wherein the phosphonic acid enhances performance of the composite (as compared to another composite having substantially the same formulation but without the phosphonic acid) by one or more of:
improving rheological properties of the composite;
improving aging properties of the composite;
improving shelf life of the composite;
improving tack/adhesion; and/or
reducing the spreading of material(s), if any, migrating from the composite.

9. The composite of any one of the preceding claims, wherein:
the phosphonic acid increases flow rate (grams/minute) of the composite as compared to another composite having substantially the same formulation but without the phosphonic acid; and/or
the phosphonic acid increases the time until brittle as compared to another composite having substantially the same formulation but without the phosphonic acid at one or more of:
150 °C or 200 °C;
85 percent relative humidity and a temperature of 40 °C;
85 percent relative humidity and a temperature of 85 °C; and/or
85 percent relative humidity and a temperature of 130 °C;
whereby the time until brittle is determinable by measuring one or more of thermal resistance, shore hardness, and/or bend radius.

10. The composite of any one of the preceding claims, wherein:
the phosphonic acid enables the composite to achieve a higher deflection as compared to another composite having substantially the same formulation but without the phosphonic acid; and/or
the phosphonic acid reduces minimum bond line thickness (BLT) of the composite as compared to another composite at an equivalent pressure that has substantially the same formulation but without the phosphonic acid; and/or
the phosphonic acid lowers elastic modulus of the composite as compared to another composite having substantially the same formulation but without the phosphonic acid.

11. The composite of any one of the preceding claims, wherein:
the phosphonic acid enhances tackiness as compared to another composite having substantially the same formulation but without the phosphonic acid, whereby the tackiness is determinable by measuring peak detached pressure and/or adhesion of the composite; and/or
the phosphonic acid reduces thermal resistance of the composite having substantially the same formulation but without the phosphonic acid.

12. The composite of any one of the preceding claims, wherein:
the one or more fillers comprise one or more of alumina, zinc oxide, aluminum, carbonyl iron, silicon carbide, boron nitride, silver, aluminum nitride, barium titanate, carbon, and graphite; and/or
the one or more fillers have a D₅₀ median particle size in a range from about 0.1 micrometers to about 500 micrometers.

13. The composite of any one of the preceding claims, wherein:
the matrix comprises a polymer-based resin system, such as a crosslinked siloxane resin system, an uncrosslinked siloxane resin system, an uncrosslinked hydrocarbon resin system, or a crosslinked hydrocarbon resin system; and
the one or more fillers comprise thermally-conductive particles that include one or more of alumina, zinc oxide, and/or aluminum and that are pretreated with the phosphonic acid, surface-modified with the phosphonic acid, and/or coated with the phosphonic acid.

14. The composite of any one of the preceding claims, wherein:
the composite is a thermal interface material, an EMI absorber material, a thermally-conductive absorber material, an electrically-conductive material, or a combination of two or more thereof; and/or
the composite is a thermal phase change material, a thermal putty, a thermal grease, a dispensable thermal interface material, and/or a thermal gap filler pad.

15. A device or system comprising the composite of any one of the preceding claims used for managing thermal properties of the device or system.
